# EUROPEAN PATENT APPLICATION

(11) **EP 1 986 225 A1**
(43) Date of publication of application: **29.10.2008**
(21) Application number: 06843264.0
(22) Date of filing: 26.12.2006
(51) Int. Cl.: H01L 21/3065, C23C 16/44, H01L 21/205

(54) **PLASMA ETCHING METHOD**

(30) Priority: 31.01.2006 JP 2006023393
(71) Applicant: Sharp Kabushiki Kaisha, Osaka-shi, Osaka 545-8522 (JP)
(72) Inventor: KISHIMOTO, Katsushi, Soraku-gun, Kyoto 619-0232 (JP)
(74) Representative: Müller - Hoffmann & Partner
(86) International application number: PCT/JP2006/325880
(87) International publication number: WO 2007/088692

(57) **Abstract**

A diluent gas that is more likely to be decomposed than an etching gas is used to generate a plasma. The etching gas is thereafter introduced into a plasma processing reaction chamber (101) and the flow rate is adjusted so that the flow rate of the etching gas is increased while simultaneously the flow rate of the diluent gas is decreased by an amount substantially equal to the increase of the flow rate of the etching gas. Thus, a variation of the pressure in the plasma processing reaction chamber (101) is reduced. Further, the gas flow rate is set to a predetermined value to satisfy desired conditions while keeping the generated plasma.

## Description

### TECHNICAL FIELD

The present invention relates to a plasma etching method, and more specifically to a method of generating a plasma.

### BACKGROUND ART

A plasma etching apparatus introduces an etching gas into a plasma processing reaction chamber in which a pair of a cathode electrode and an anode electrode is provided, adjusts the pressure of a gas mixture in the reaction chamber to be substantially constant by means of a pressure adjustment valve provided to an exhaust system of the plasma processing reaction chamber, and applies a high voltage between the electrodes to generate a plasma and thereby plasma-process a work placed on the cathode electrode or anode electrode.

Some problems have been pointed out regarding the plasma etching apparatus in a transient state where a high voltage is applied between electrodes to generate a glow discharge plasma.

For example, Japanese Patent Laying-Open No. 8-165584 (Patent Document 1) indicates a problem as follows. The period of time from the time when an electric power is applied to the time when discharge has become stable is not constant and thus the reproducibility of plasma processing cannot be achieved even if the time after the discharge has become stable is adjusted to be constant.

As a means for solving this problem, a plasma processing method is disclosed according to which an inert gas is introduced into a vacuum vessel, a predetermined degree of vacuum is kept and a high-frequency electric power is supplied to electrodes to generate a plasma and, after the plasma has become stable, the inert gas is replaced with a reaction gas.

According to this method, unnecessary and disadvantageous deposition and etching can be prevented from occurring until the discharge has become stable and, based on the time from the time when the inert gas is replaced with the reaction gas to start required deposition or etching to the time when the discharge is stopped, the processing time can be controlled, so that the reproducibility of the result of the plasma processing can be improved.

Further, Japanese Patent Laying-Open No. 2002-246317 (Patent Document 2) indicates a problem that an unintended low-quality thin film is undesirably formed, because a species to be deposited that is generated from a plasma as well as the density thereof are not appropriate until a gas decomposition process has become a steady state in the initial stage of the discharge of the plasma CVD method.

As a means for solving this problem, a method is disclosed according to which only a hydrogen gas that is a diluent gas is initially introduced into a reaction chamber to generate a glow discharge plasma, then a feedstock gas is introduced into the reaction chamber while the flow rate of the feedstock gas is gradually increased, and the gas is decomposed by the glow discharge plasma to form a thin film.

It is described that this method provides the following effect. It can be avoided that a film is formed of an unwanted film-deposition species generated in an unstable plasma in the initial stage of the start of discharge. In other words, many favorable film-deposition species are present in the plasma diluted with high-concentration hydrogen. Therefore, by adding a feedstock gas under this condition, many favorable film-deposition species are generated so that a thin film of good quality can be formed in the initial stage of thin-film deposition.
Patent Document 1: Japanese Patent Laying-Open No. 8-165584
Patent Document 2: Japanese Patent Laying-Open No. 2002-246317

### DISCLOSURE OF THE INVENTION

### PROBLEMS TO BE SOLVED BY THE INVENTION

Patent Document 1 merely describes that the inert gas is replaced with the reaction gas. There is the problem that the pressure in the vacuum vessel changes to a great degree when the gas is replaced and, in this transient state, the plasma becomes unstable so that the glow discharge plasma between electrodes is extinguished.

Further, according to Patent Document 2, the feedstock gas is introduced into the reaction chamber while the flow rate is gradually increased after the glow discharge plasma of the hydrogen gas which is a diluent gas is generated. However, according to the description of examples, the pressure in the reaction chamber in each process step is set to a constant value.

In this case, it seems unlikely that all of the introduced feedstock gas is decomposed by the plasma. It is thus considered that the pressure in the reaction chamber is increased as the flow rate of the feedstock gas is increased. It seems that the pressure increase is restricted by a pressure adjustment valve provided to an exhaust system of the reaction chamber so that the pressure is adjusted to a substantially constant pressure.

In general, the pressure in the reaction chamber is adjusted by the pressure adjustment valve through feedback of the indicated value of the pressure meter measuring the pressure in the reaction chamber. Therefore, there arises the problem as follows. If the flow rate of the gas introduced into the reaction chamber changes, the change in pressure will increase even while the pressure is adjusted.

There is another problem that, depending on the structure of the electrodes of the plasma etching apparatus, generation of a glow discharge plasma using an etching gas is difficult, and accordingly a large electric power is required for generating a plasma.

The present invention has been made in view of the above-described issues. An object of the present invention is to provide a plasma etching method with which the electric power required for generating a glow discharge plasma between electrodes of the plasma etching apparatus is reduced and a plasma of desired conditions is generated.

Another object is to provide a plasma etching method with which plasma etching can be performed without exerting an excessive load on a plasma processing apparatus that is designed to comply with optimum conditions for plasma film deposition, in the case where plasma film deposition and plasma etching are performed with the same apparatus.

### MEANS FOR SOLVING THE PROBLEMS

For achieving the objects above, the present invention is a plasma etching method including: a diluent gas introducing step of introducing a diluent gas into a plasma processing reaction chamber; a pressure adjusting step of adjusting a pressure in the plasma processing reaction chamber to be substantially constant; a plasma generating step of generating a glow discharge plasma by applying an electric power to an electrode provided in the plasma processing reaction chamber; a gas control step of introducing an etching gas into the plasma processing reaction chamber and increasing a flow rate of the etching gas while simultaneously decreasing a flow rate of the diluent gas by an amount substantially equal to an increase of the flow rate of the etching gas; and an etching step of performing etching by setting respective flow rates of the diluent gas and the etching gas to processing flow rate values respectively, and the diluent gas introducing step, the pressure adjusting step, the plasma generating step, the gas control step and the etching step are performed in this order.

According to the present invention, in the step of generating the plasma between the electrodes, the diluent gas which is more likely to be decomposed than the etching gas is first introduced so that the plasma discharge is readily generated between the electrodes. Next, the flow rate of the diluent gas is decreased by the amount substantially equal to the flow rate of the introduced etching gas to keep substantially constant the pressure in the plasma processing reaction chamber. The plasma under desired etching conditions can be generated by setting respective flow rates of the diluent gas and the etching gas to processing flow rate values, without extinguishing the plasma between the electrodes.

Further, according to the present invention, it is preferable that, in the gas control step, the step of introducing the etching gas and increasing the flow rate of the etching gas while simultaneously decreasing the flow rate of the diluent gas by the amount substantially equal to an increase of the flow rate of the etching gas is performed a plurality of times.

Further, according to the present invention, it is preferable that, in the gas control step, respective flow rates of the diluent gas and the etching gas are changed continuously.

Further, according to the present invention, preferably the electric power applied to the electrode in the plasma generating step is set to an initial electric power value, the electric power is increased from the gas control step to the etching step, and the electric power is fixed when the electric power reaches a processing electric power value in the etching step.

Further, according to the present invention, preferably the electric power is increased continuously in the gas control step and the etching step.

Further, according to the present invention, preferably the electric power applied to the electrode is fixed at the processing electric power value after an end of the gas control step and after the flow rate of the gases becomes stable.

Further, according to the present invention, preferably an impedance matching circuit is provided between the electrode and a power supply supplying an electric power to the electrode, and the impedance matching circuit is fixed in an impedance-matched state in a steady state of the etching step.

Further, according to the present invention, preferably after a predetermined period of time has passed since an end of the gas control step, the impedance matching circuit starts an automatic matching operation.

Further, according to the present invention, a power supply is connected to a plurality of electrodes provided in the plasma processing reaction chamber via an impedance matching circuit.

Further, a plasma etching apparatus with which the plasma processing method of the present invention is performed is used as both of the plasma etching apparatus and a plasma CVD apparatus.

### EFFECTS OF THE INVENTION

The present invention is a plasma etching method including: a diluent gas introducing step of introducing a diluent gas into a plasma processing reaction chamber; a pressure adjusting step of adjusting a pressure in the plasma processing reaction chamber to be substantially constant; a plasma generating step of generating a glow discharge plasma by applying an electric power to an electrode provided in the plasma processing reaction chamber; a gas control step of introducing an etching gas into the plasma processing reaction chamber and increasing a flow rate of the etching gas while simultaneously decreasing a flow rate of the diluent gas by an amount substantially equal to an increase of the flow rate of the etching gas; and an etching step of performing etching by setting respective flow rates of the diluent gas and the etching gas to processing flow rate values respectively, and the diluent gas introducing step, the pressure adjusting step, the plasma generating step, the gas control step and the etching step are performed in this order.

First, the diluent gas which is more likely to be decomposed than the reaction gas can be used to easily generate the plasma between the electrodes. Then, the flow rate of the diluent gas is decreased while simultaneously the etching gas is increased by the amount substantially equal to the decrease of the flow rate of the diluent gas, so that a variation of the pressure in the plasma processing reaction chamber can be kept small in the step of introducing the etching gas. Thus, respective flow rates of the diluent gas and the etching gas can be set to desired processing flow rate values without extinguishing the plasma generated between the electrodes. With this method, a plasma of desired conditions can be generated with a smaller electric power.

### BRIEF DESCRIPTION OF THE DRAWINGS

Fig. 1 shows a schematic cross section and a gas pipe system of a plasma etching apparatus with which a plasma etching method is performed according to embodiments of the present invention.
Fig. 2 is a time chart of a plasma processing method according to a first embodiment of the present invention.
Fig. 3 is a time chart of a plasma processing method according to a second embodiment of the present invention.
Fig. 4 is a schematic cross section of a plasma etching apparatus with which a plasma etching method is performed according to a third embodiment of the present invention.
Fig. 5 is a time chart of a plasma processing method according to Example 1 of the present invention.

### DESCRIPTION OF THE REFERENCE SIGNS

101 plasma processing reaction chamber, 102 cathode electrode, 103 anode electrode, 104 power supply, 105 impedance matching circuit, 108 diluent gas, 109 etching gas

### BEST MODES FOR CARRYING OUT THE INVENTION

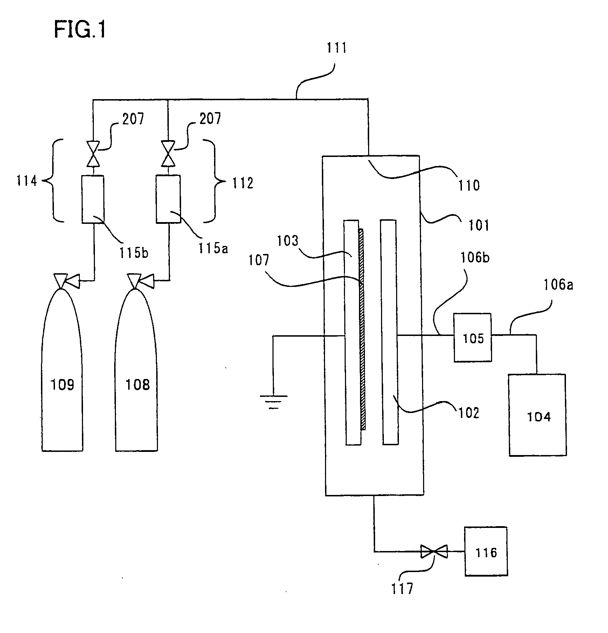

Fig. 1 shows a schematic cross section and a gas pipe system of a plasma etching apparatus with which a plasma etching method is performed according to embodiments of the present invention.

In a hermetically sealable plasma processing reaction chamber 101, a pair of a cathode electrode 102 and an anode electrode 103 is placed. The electrode-to-electrode distance between cathode electrode 102 and anode electrode 103 is determined according to desired etching conditions. On the outside of plasma processing reaction chamber 101, a power supply 104 for supplying an electric power to cathode electrode 102 and an impedance matching circuit 105 performing impedance matching between power supply 104 and the pair of cathode electrode 102 and anode electrode 103 are placed. Impedance matching circuit 105 can be set in a manual operation mode fixed in a certain state. Impedance matching circuit 105 can also be set in an automatic matching operation mode of operating in such a manner that a reflected electric power to power supply 104 is minimum.

One end of an electric power introducing line 106a is connected to power supply 104, and the other end thereof is connected to impedance matching circuit 105. One end of an electric power introducing line 106b is connected to impedance matching circuit 105, and the other end thereof is connected to cathode electrode 102.

In contrast, anode electrode 103 is electrically grounded. On anode electrode 103, a work 107 that is an object to undergo plasma etching is placed. Work 107 may alternatively be placed on cathode electrode 102.

Plasma processing reaction chamber 101 is provided with a gas inlet 110. One end of a gas introducing pipe 111 is connected to gas inlet 110, and the other end thereof is connected to a diluent gas feeding unit 112 and an etching gas feeding unit 114. Diluent gas feeding unit 112 is provided with a flow rate adjustment device 115a such as a mass flow controller for adjusting the flow rate of a diluent gas 108, as well as a valve 207 at an appropriate position. As diluent gas 108, an inert gas such as Ar, He, Ne or N₂ is used.

Etching gas feeding unit 114 is provided with a flow rate adjustment device 115b such as a mass flow controller for adjusting the flow rate of an etching gas 109 introduced into plasma processing reaction chamber 101. As etching gas 109, NF₃ or CF₄ for example is used. Etching gas 109 to be used is any gas in which discharge is more unlikely to be caused and which is more unlikely to be decomposed by application of a voltage, as compared with diluent gas 108.

Further, to plasma processing reaction chamber 101, a vacuum pump 116 and a pressure adjustment valve 117 are connected in series, for keeping the gas pressure in plasma processing reaction chamber 101 substantially constant.

The degree of opening of pressure adjustment valve 117 is automatically adjusted so that an indicated value of a pressure meter measuring the pressure in plasma processing reaction chamber 101 is constant.

In the plasma etching apparatus having the above-described configuration, the plasma etching method of the present invention is performed.

In the present embodiment, the apparatus is used exclusively as a plasma etching apparatus. The apparatus, however, may be used as both of the plasma etching apparatus and a plasma CVD apparatus. It is a common practice that the apparatus is used as a plasma CVD apparatus to form a film on work 107, work 107 is thereafter removed, and then the apparatus is used as a plasma etching apparatus so as to clean a film away that is attached to anode electrode 102 and cathode electrode 103.

In the case of such a multi-purpose apparatus as described above, the configuration of the apparatus is designed mainly on the basis of the conditions when a thin film is deposited. Therefore, the electrode-to-electrode distance between anode electrode 102 and cathode electrode 103 as well as the range of the pressure to be set are set to conditions appropriate for the plasma CVD apparatus. In general, the voltage at which discharge is started between anode electrode 102 and cathode electrode 103 is determined depending on the gas species, gas pressure, electrode-to-electrode distance and shape of the electrode, for example. In the case where the apparatus is used as the plasma etching apparatus, a plasma may not be readily generated between anode electrode 102 and cathode electrode 103. The present invention is applicable to the apparatus as described above, so that a plasma etching process can be performed.

### First Embodiment

In the following, a plasma etching method according to a first embodiment of the present invention will be described.

First, diluent gas 108 is introduced into plasma processing reaction chamber 101, and the flow rate of diluent gas 108 is set to a constant flow rate value by flow rate adjustment device 115a (ST1: diluent gas introducing step).

Next, the pressure in etching reaction chamber 101 is kept at a pressure of a substantially constant value by pressure adjustment valve 117 (ST2: pressure adjusting step). Here, the set pressure has a pressure value with which desired etching conditions such as etching rate are satisfied in an etching step.

Then, an electric power having a processing electric power value is supplied from power supply 104 to cathode electrode 102 to generate a glow discharge plasma between anode electrode 103 and cathode electrode 102 (ST3: plasma generating step). Here, the processing electric power value is at least a minimum electric power that can cause a glow discharge plasma to generate between anode electrode 103 and cathode electrode 102, and is an electric power value with which desired etching conditions such as etching rate are satisfied.

Then, etching gas 109 is introduced into the plasma processing reaction chamber, and flow rate adjustment devices 115a and 115b are adjusted in such a manner that the flow rate of etching gas 109 increases while simultaneously the flow rate of diluent gas 108 decreases by an amount substantially equal to an increase of the flow rate of the etching gas (ST4: gas control step).

When respective flow rates of diluent gas 108 and etching gas 109 become respective processing flow rate values, the flow rate values are fixed and etching is performed (ST5: etching step). Here, the processing flow rate values are each a gas flow rate value with which desired etching conditions such as etching rate are satisfied.

Through the above-described steps, even in the case where a glow discharge plasma is not readily generated between the electrodes under desired etching conditions (in the state where diluent gas 108 and etching gas 109 having processing flow rate values are introduced and the pressure is set to a desired pressure), plasma etching of desired conditions can be implemented by setting respective flow rates of diluent gas 108 and etching gas 109 to respective processing flow rate values, without extinguishing the plasma generated using diluent gas 108 in step ST3.

Specifically, diluent gas 108 that is more likely to decompose and that is more likely to cause a discharge than etching gas 109 is firstly used. Thus, an applied electric power required to generate a plasma can be reduced. After this, in the state where the plasma is generated by means of diluent gas 108, etching gas 109 is introduced. Since the energy of the generated plasma is large, the energy promotes decomposition of etching gas 109. Therefore, the plasma is not readily extinguished even if etching gas 109 is introduced.

Further, after the plasma is generated using diluent gas 108, the gas flow rate is adjusted to decrease the flow rate of diluent gas 108 while simultaneously increase the flow rate of etching gas 109 by an amount substantially equal to the decrease of the flow rate of the diluent gas. In this way, the variation of the pressure in etching reaction chamber 101 when etching gas 109 is introduced can be reduced, extinction of the plasma can be prevented, and the plasma can be maintained even in the state where respective flow rates of diluent gas 108 and etching gas 109 are set to the processing flow rate values.

As flow rate adjustment devices 115a and 115b, a mass flow controller for example is used. The mass flow controller adjusts the gas flow rate by setting the opening degree of a flow path to a predetermined state, and thus has the advantage that the time required to adjust the flow rate can be shortened as compared with the configuration of feeding back the actual flow rate value to adjust the flow rate.

In general, at the time when closed valve 207 is opened to start flowing the gas, the flow rate temporarily increases. The mass flow controller is preferable in that the flow rate can be continuously changed in the later flow rate adjustment.

In the above-described gas control step, it is desirable that the flow rate adjustment step in which etching gas 109 is introduced and the flow rate of the etching gas is increased while simultaneously the flow rate of diluent gas 108 is decreased by an amount substantially equal to an increase of the flow rate of the etching gas is performed multiple times and step-by-step to change respective flow rates of diluent gas 108 and etching gas 109 until the flow rates become respective processing flow rate values. It is also desirable that the flow rate of etching gas 109 continuously increases and the flow rate of diluent gas 108 continuously decreases.

The flow rate of etching gas 109 is increased and the flow rate of diluent gas 108 is decreased in a stepwise or continuous manner, and accordingly it can be achieved that a pressure variation at the time when etching gas 109 is introduced is reduced and that a plasma which has once been generated is not readily extinguished.

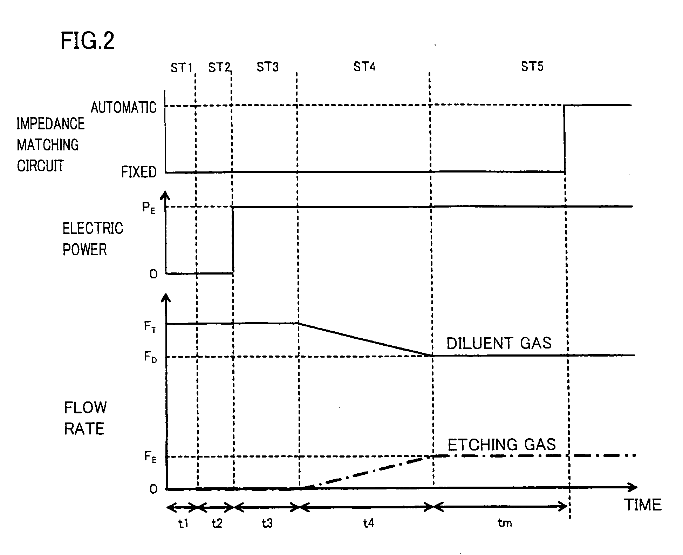

Each of the above-described steps will be described in more detail based on the drawings. Fig. 2 is a time chart of the plasma processing method according to the present embodiment.

In diluent gas introducing step ST1, flow rate F_{T} of diluent gas 108 is equal to total flow rate F_{T} of diluent gas 108 and etching gas 109 in the etching step, and total flow rate F_{T} is constant from pressure adjusting step ST2 to etching step ST5.

In gas control step ST4, the flow rate of etching gas 109 is increased by the amount corresponding to the decrease of the flow rate of diluent gas 108. Therefore, the total flow rate is also constant. The flow rate of diluent gas 108 and the flow rate of etching gas 109 in the gas control step ST4 are changed continuously.

The set pressure in pressure adjusting step ST2 is equal to the pressure in etching step ST5, and the pressure is constant from pressure adjusting step ST2 to etching step ST5. In gas control step ST4, the flow rate of etching gas 109 is increased by the amount corresponding to the decrease of the flow rate of diluent gas 108. Therefore, the pressure variation can be reduced and the pressure can be kept at a substantially constant value as well. In etching step ST5 after gas control step ST4 is ended, respective flow rates of diluent gas 108 and etching gas 109 are set to processing flow rate values F_{D} and F_{E} respectively.

An AC (Alternating Current) power supply is generally used as power supply 104. Electric power P_{E} that is output from power supply 104 in plasma generating step ST3 is equal to output electric power P_{E} in etching step ST5. Output electric power P_{E} may be at least an electric power that can cause a glow discharge plasma to generate between anode electrode 103 and cathode electrode 102 in plasma generating step ST3.

Further, impedance matching circuit 105 is set in a constant state from plasma generating step ST3 to the time when a predetermined period of time tm has passed since the end of gas control step ST4. It is desirable that the set state is such a state where a reflected electric power is minimum in a steady state of etching step ST5. The set state is measured and obtained in advance.

Here, the steady state of plasma processing step ST5 refers to the state in which respective flow rates of diluent gas 108 and etching gas 109 are adjusted to processing flow rate values F_{D} and F_{E}, the output electric power of power supply 104 is P_{E} and the state of the plasma is substantially stable under the condition that the pressure in etching reaction chamber 101 is adjusted to a desired pressure value. In the present embodiment, the steady state refers to a state in which the state of the plasma is substantially stable after a sufficient time has passed since the start of etching step ST5.

Further, predetermined period of time tm is set so that the above-described steady state is reached when predetermined period of time tm has passed since the end of gas control step ST4.

Generally, impedance matching circuit 105 automatically performs impedance matching so that a reflected electric power to power supply 104 is minimum. However, the impedance matching cannot follow a sudden variation of a load (impedance between the electrodes in the present embodiment), and thus cannot follow a variation of the impedance between anode electrode 103 and cathode electrode 102 when the plasma is generated in plasma generating step ST3 or when etching gas 109 is introduced in gas control step ST4. Accordingly, there could be a large deviation from the impedance matching point. As a result, the reflected electric power to power supply 104 increases and a sufficient electric power is not supplied to cathode electrode 102, and accordingly a problem arises that a plasma between anode electrode 103 and cathode electrode 102 is not generated or extinguished.

The large deviation from the impedance matching point can be prevented by fixing impedance matching circuit 105 in an impedance-matched state in the steady state of plasma processing step ST5, and the problem that a plasma is not generated and a plasma is extinguished due to impedance mismatch can be solved.

Further, it is desirable that, in etching step ST5, impedance matching circuit 105 is caused to automatically perform the matching operation after predetermined period of time tm has passed since the end of gas control step ST4. Predetermined period of time tm may be set so that impedance matching circuit 105 starts performing the automatic matching operation after the above-described steady state is reached. Predetermined period of time tm varies depending on the volume of etching reaction chamber 101, the flow rate of the introduced gas and the set pressure value. Therefore, the value of predetermined period of time tm has to be set appropriately.

In the above-described steady state, a variation of the impedance between anode electrode 103 and cathode electrode 102 is small. Therefore, the automatic matching operation can follow the load variation, and thus the impedance matching is more precisely performed and the electric power can be efficiently supplied from power supply 104 to cathode electrode 102.

### Second Embodiment

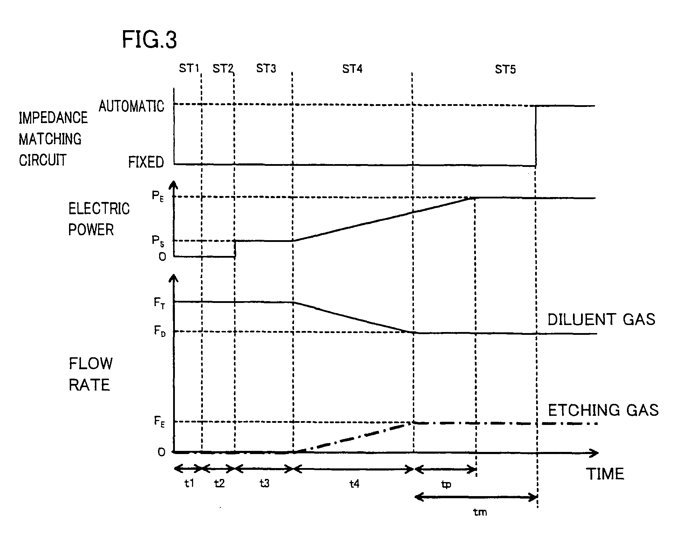

A plasma etching method according to a second embodiment of the present invention will be described based on the drawings. Fig. 3 is a time chart of a plasma processing method according to the present embodiment.

The settings in the second embodiment are similar to those of the first embodiment except for the setting of the electric power that is output from power supply 104.

In the present embodiment, in plasma generating step ST3, the electric power that is output from power supply 104 to cathode electrode 102 is set to initial electric power value P_{S}, the output electric power value is increased from gas control step ST4 to etching step ST5, and the output electric power value is fixed at processing electric power value P_{E} in etching step ST5.

It is necessary that initial electric power value P_{S} in plasma generating step ST3 is at least an electric power that can cause a glow discharge plasma to generate between anode electrode 103 and cathode electrode 102. The present embodiment, however, differs from the first embodiment in that the electric power may be any that can generate a plasma in plasma generating step ST3, and the electric power that can keep the plasma in etching step ST5 is unnecessary. Namely, a smaller electric power than that in the first embodiment is enough in the present embodiment.

In gas control step ST4, etching gas 109 that is less likely to be decomposed than diluent gas 108 is introduced. Therefore, unless the set value of the output electric power is increased from initial electric power value P_{S}, the plasma generated between the electrodes is extinguished. In the present embodiment, the set value of the output electric power is increased from gas control step ST4 to etching step ST5 and accordingly the plasma once generated between the electrodes can be kept.

In the case where diluent gas 108 is used that is more likely to be decomposed to cause discharge by application of a voltage than etching gas 109, a glow discharge plasma is likely to occur in any portion other than the portion between the electrodes. For example, a plasma may be generated in a portion where an electrically insulating material such as ceramic is used. If an excessive electric power is applied, the portion may possibly be broken.

In the present embodiment, the electric power applied to cathode electrode 102 is kept small and increased gradually from plasma generating step ST3 to gas control step ST4. Therefore, even if a plasma is generated in a portion other than the portion between the electrodes, a damage caused by the plasma to the apparatus can be reduced.

Further, it is desirable that the electric power applied between the electrodes in gas control step ST4 and etching step ST5 is increased continuously. This is for the reason that, if the amount of applied electric power suddenly increases, a plasma is likely to occur in a portion other than the portion between the electrodes and accordingly there is a higher possibility of the damage to the apparatus as described above.

Further, in the present embodiment, the electric power that is output from power supply 104 is fixed at processing electric power value P_{E} after the end of gas control step ST4 and after the gas flow rate becomes stable (after a period of time tp has passed) in etching step ST5.

After the end of gas control step ST4 and in etching step ST5, respective flow rates of diluent gas 108 and etching gas 109 are set to processing flow rate values F_{D} and F_{E}. However, even if respective flow rates of flow rate adjustment devices 115a and 115b are set, the flow rate of the gas actually introduced into etching reaction chamber 101 does not immediately become stable, namely a time lag is generated.

Accordingly, in the present embodiment, after respective flow rates of flow rate adjustment devices 115a and 115b are set to processing flow rate values F_{D} and F_{E} and after the gas flow rate becomes stable (after period of time tp has passed), the electric power applied between the electrodes is fixed at processing electric power value P_{E}.

The above-described time lag is more noticeable as work 107 is larger in size, the volume of etching reaction chamber 101 is larger and the gas flow rate is higher. Accordingly, the period of time tp has to be adjusted.

### Third Embodiment

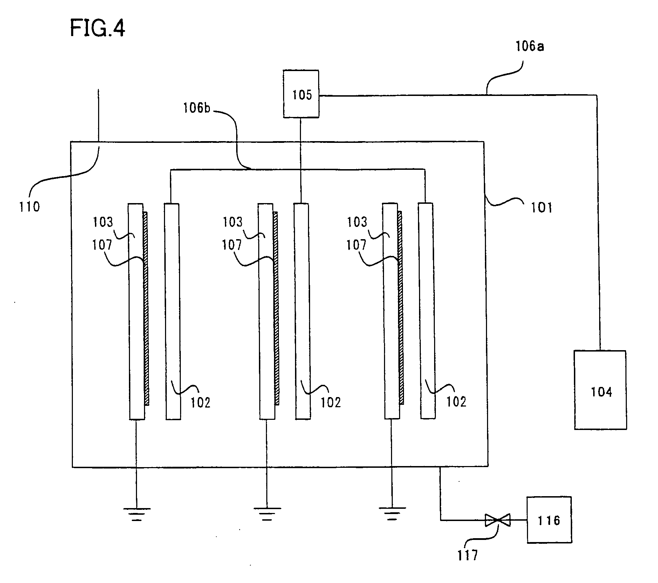

In the first embodiment and the second embodiment, the electric power is applied from power supply 104 through impedance matching circuit 105 to one pair of anode electrode 103 and cathode electrode 102. Alternatively, as shown in Fig. 4, a plurality of pairs of anode electrodes 103 and cathode electrodes 102 may be connected to one impedance matching circuit 105.

In this case, it is difficult to simultaneously generate the glow discharge plasma between respective anode electrodes 103 and cathode electrodes 102 of the plurality of pairs. In other words, if the glow discharge plasma is generated between a part of the electrodes of a plurality of pairs, the impedance between the electrodes is smaller. Accordingly, the electric power supplied between other electrodes is smaller and the plasma is not generated between these electrodes.

In order to solve this problem, it is necessary to apply a voltage larger than the discharge start voltage between the electrodes of each pair. As the voltage applied between the electrodes of each pair is larger, there is a higher possibility of simultaneous generation of the glow discharge plasma between electrodes. Therefore, the output electric power of power supply 104 has to be increased.

The plasma etching method of the present invention is also effective for the plasma etching apparatus thus configured. Thus, the value of the applied voltage necessary for simultaneously generating the glow discharge plasma between a plurality of electrodes can be reduced and thus the output electric power of power supply 104 can be reduced.

### Example 1

The schematic cross section of a plasma etching apparatus in this example is similar to that of Fig. 1, and a description will be given based on Fig. 1 hereinafter. Anode electrode 103 and cathode electrode 102 are placed to face each other in plasma processing reaction chamber 101, the etching gas and diluent gas 108 are introduced into plasma processing reaction chamber 101, and an electric power is supplied to cathode electrode 102 to generate a glow discharge plasma between anode electrode 103 and cathode electrode 102.

This plasma etching apparatus will be described more specifically. Hermetically sealable and vertically-oriented plasma processing reaction chamber 101 was provided, and a pair of cathode electrode 102 and anode electrode 103 was disposed substantially perpendicularly to the bottom surface of plasma processing reaction chamber 101. On a surface of anode electrode 103, a glass substrate on which a silicon thin film was deposited was placed as work 107 that was an object to be processed.

For plasma processing reaction chamber 101, a material such as stainless steel or aluminum alloy was used, and a ceramic or the like was used as a heat insulator. Anode electrode 103 was made of a material having electrical conductivity and heat insulation such as stainless steel, aluminum alloy or carbon.

Work 107 is not limited to a particular one as long as the work is an object to be etched. Further, in the case where the apparatus is used as both of the plasma etching apparatus and a plasma CVD apparatus and the inside of the reaction chamber is to be cleaned, work 107 may not be placed.

The dimension of anode electrode 103 was determined to be an appropriate value according to the dimension of work 107 to be etched. In the present example, with respect to the glass substrate dimension of 900 mm × 900 mm, the dimension of anode electrode 103 was 1000 mm × 1000 mm.

Although cathode electrode 102 was made of an aluminum alloy, the cathode electrode may be made of a stainless steel or the like instead. The dimension of cathode electrode 102 was set to an appropriate value according to the dimension of work 107. In the present example, the dimension of the cathode electrode was 1000 mm × 1000 mm.

Respective sizes of anode electrode 103, cathode electrode 102 and the glass substrate are not limited to the above-described ones. While the sizes may be any, the sizes are usually in the range of the size of 500 to 1500 mm.

The electrode-to-electrode distance between anode electrode 103 and cathode electrode 102 was set to 20 mm. This electrode-to-electrode distance is usually adjusted between a few mm to a few tens of mm.

Plasma processing reaction chamber 101 was provided with gas inlet 110. One end of diluent gas introducing pipe 111 was connected to gas inlet 110, and the other end thereof was connected to diluent gas feeding unit 112. Diluent gas feeding unit 112 was provided with a mass flow controller as flow rate adjustment device 115 for controlling the flow rate and supplying diluent gas 108. Ar gas was used as diluent gas 108.

One end of etching gas introducing pipe 113 was connected to diluent gas introducing pipe 111 and the other end thereof was connected to etching gas feeding unit 114. Etching gas feeding unit 114 was provided with a mass flow controller so that the flow rate could be adjusted. NF₃ gas was used as etching gas 109.

For an exhaust system of plasma processing reaction chamber 101, pressure adjustment valve 117 and vacuum pump 116 were provided in series so that the gas pressure in plasma processing reaction chamber 101 could be kept substantially constant.

In the present example, 5 SLM of Ar gas that was diluent gas 108 and 1 SLM of NF₃ gas that was etching gas 109 were flown, and the gas pressure in plasma processing reaction chamber 101 was 300 Pa. These conditions are given by way of example, and other gas flow rates and another gas pressure may be used. However, usually respective gas flow rates of the Ar gas and the NF₃ gas are set in the range of 1 to 5 SLM and 0.1 to 1 SLM respectively, and the gas pressure is set in the range of 30 to 500 Pa.

To cathode electrode 102, an electric power was supplied by plasma excitation power supply 104. As power supply 104, an AC power supply with a frequency of 13.56 MHz and an output power of 1 kW was used. In general, an AC power supply with a frequency of 1.00 MHz to 100 MHz and an output electric power of approximately 10 W to 100 kW is used as power supply 104. Alternatively, a DC power supply may be used.

Between power supply 104 and plasma processing reaction chamber 101, impedance matching circuit 105 performing impedance matching between cathode electrode 102, anode electrode 103 and power supply 104 was placed. Power supply 104 and impedance matching circuit 105 were connected by electric power introducing line 106a, and impedance matching circuit 105 and cathode electrode 102 were connected by electric power introducing line 106b. Anode electrode 103 was electrically grounded.

In the plasma etching apparatus configured as described above, a high-frequency electric power was applied to cathode electrode 102 to generate a glow discharge plasma between cathode electrode 102 and anode electrode 103 and etch a silicon thin film on the surface of work 107.

This plasma etching apparatus can be used for etching a silicon-based material, for example.

With the above-described plasma etching apparatus, the plasma processing method in the present example is implemented. In the following, an example of the plasma processing method of the present invention will be described with reference to the drawings.

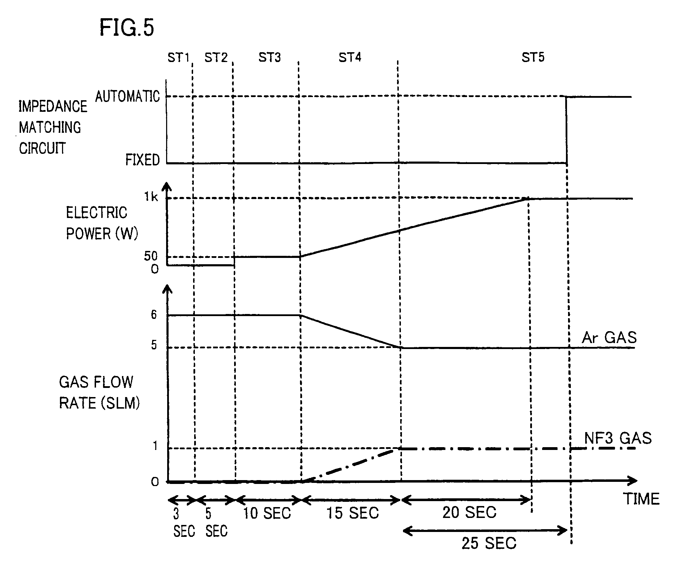

Fig. 5 is a time chart of the plasma processing method in the present example.

In diluent gas introducing step ST1, the flow rate of the Ar gas was 6 SLM.

In pressure adjusting step ST2, the pressure in plasma processing reaction chamber 101 into which the Ar gas was introduced was adjusted by pressure adjustment valve 117 to 300 Pa. This pressure was constant from pressure adjusting step ST2 to etching step ST5.

In plasma generating step ST3, an electric power of 50 W was output from power supply 104 to generate a glow discharge plasma by the Ar gas between cathode electrode 102 and anode electrode 103. Here, impedance matching circuit 105 was fixed to the setting such that the reflected electric power was minimum in the steady state of etching step ST5 (the conditions that the Ar gas flow rate was 5 SLM, the NF₃ gas flow rate was 1 SLM, the gas pressure in plasma processing reaction chamber 101 was 300 Pa, and the output electric power of power supply 104 was 1 kW).

In gas control step ST4, the flow rate of the Ar gas was continuously decreased from 6 SLM to 5 SLM. Simultaneously with the decreasing of the Ar gas, the NF₃ gas was increased by the amount substantially equal to the decrease of the flow rate of the Ar gas. By this settings, the total flow rate of the Ar gas and NF₃ gas was 6 SLM and thus constant. In gas control step ST4, the plasma generated between cathode electrode 102 and anode electrode 103 in plasma generating step ST3 was kept, while respective flow rates of the Ar gas and the NF₃ gas were changed respectively to the flow rates of 5 SLM and 1 SLM. In the subsequent etching step ST5, the flow rates were set to these processing flow rate values. At this time, in terms of etching efficiency, it is generally desirable that the concentration of the NF₃ gas in the gas mixture of the Ar gas and the NF₃ gas is 30% or less.

The output electric power of power supply 104 was set such that the output electric power continuously increased from the initial electric power value of 50 W from gas control step ST4 to etching step ST5 and the output electric power reached 1 kW when 20 seconds passed from the end of gas control step ST4, and the output electric power was kept at the constant electric power value thereafter.

In etching step ST5, when 25 seconds passed from the end of gas control step ST4, impedance matching circuit 105 was set in the automatic matching operation mode.

In the configuration of the apparatus in the present example, even if impedance matching circuit 105 was adjusted with the output electric power of power supply 104 of 1 kW under the conditions that the Ar gas flow rate was 5 SLM, the NF₃ gas flow rate was 1 SLM and the gas pressure in plasma processing reaction chamber 101 was 300 Pa, a plasma could not be generated since the voltage applied between cathode electrode 102 and anode electrode 103 did not reach a discharge start voltage. However, the plasma processing method of the present invention could be performed to keep the plasma under similar conditions to the above-described conditions (Ar gas flow rate was 5 SLM, the NF₃ gas flow rate was 1 SLM and the gas pressure in plasma processing reaction chamber 101 was 300 Pa). Thus, the effects of the present invention could be confirmed.

### Example 2

A plasma etching apparatus in the present example was used as both of the plasma etching apparatus and a plasma CVD apparatus. Specifically, the apparatus had the function of depositing a crystalline silicon thin film and the function of etching and thereby cleaning a silicon thin film attached to cathode electrode 102 and anode electrode 103 for example in the film deposition process.

It is generally known that, when a crystalline silicon thin film is deposited using a plasma CVD apparatus, a high-quality film can be formed in the following way. A gas which is prepared by diluting an SiH₄ gas which is a feedstock gas with ten or more parts of H₂ gas which is a diluent gas is introduced into plasma processing reaction chamber 101, and the pressure in plasma processing reaction chamber 101 is set to a high pressure of approximately several hundreds of Pa.

A discharge start voltage for generating a plasma between cathode electrode 102 and anode electrode 103 depends on the gas pressure in plasma processing reaction chamber 101 and the distance between cathode electrode 102 and anode electrode 103. In the case where the gas pressure increases, the distance between the electrodes has to be decreased for reducing the discharge start voltage. In order to deposit a high-quality crystalline silicon thin film, the pressure in plasma processing reaction chamber 101 has to be increased to a certain degree as described above. In order to generate a plasma between cathode electrode 102 and anode electrode 103, it is necessary to reduce the distance between the electrodes.

The basic configuration of the plasma etching apparatus in the present example was similar to that of Example 1, except that the apparatus is configured as described below in order to keep the high-quality of the deposited crystalline silicon thin film. Specifically, the distance between cathode electrode 102 and anode electrode 103 was 10 mm which was smaller than that of Example 1, the set pressure in plasma processing reaction chamber 101 in depositing the film was 300 Pa, the flow rate of the H₂ gas was 5 SLM, the flow rate of the SiH₄ gas was 0.1 SLM, and the output electric power of power supply 104 was 1 kW.

As described above, in the case where the apparatus is used as both of the plasma CVD apparatus and the plasma etching apparatus, the elements of the apparatus such as the distance between the electrodes and the range of the set pressure are designed chiefly on the basis of conditions in depositing the thin film. Therefore, in the case where the apparatus is used as the etching apparatus, a plasma cannot be generated between cathode electrode 102 and anode electrode 103 in some cases.

In the present example, the distance between cathode electrode 102 and anode electrode 103 was 10 mm, the range of the set pressure was limited, and impedance matching circuit 105 was designed so that the circuit is optimized when the apparatus is used as the plasma CVD apparatus. Therefore, in order to generate a plasma between cathode electrode 102 and anode electrode 103 under the plasma etching conditions that the Ar gas flow rate was 5 SLM, the NF₃ gas flow rate was 1 SLM and the gas pressure in plasma processing reaction chamber 101 was 300 Pa, it was necessary to increase the output electric power from power supply 104 to approximately 5 kW.

In the present example as well, similar steps to those of Example 1 were performed, except that the initial electric power value of the output power of power supply 104 was 100 W. The output electric power of power supply 104 was set such that the output electric power continuously increased from 100 W from gas control step ST4 to etching step ST5 and the output electric power reached 1 kW when 20 seconds passed from the end of gas control step ST4, and the output electric power was thereafter kept at the constant electric power value.

The above-described step was performed and accordingly, in the configuration of the present example as well, the plasma etching could be performed with the output power of 1 kW of power supply 104 under the conditions that the Ar gas flow rate was 5 SLM, the NF₃ gas flow rate was 1 SLM and the gas pressure in plasma processing reaction chamber 101 was 300 Pa. Thus, the effect that the electric power necessary for generating a plasma can be reduced could be confirmed.

While the embodiments and examples of the present invention have been described above, it is also originally intended that some elements of the embodiments and examples be appropriately combined. It should be construed that the embodiments and examples disclosed herein are illustrative in every respect and non-restrictive.

## Claims

1. A plasma etching method comprising:
a diluent gas introducing step (ST1) of introducing a diluent gas into a plasma processing reaction chamber (101);
a pressure adjusting step (ST2) of adjusting a pressure in said plasma processing reaction chamber (101) to be substantially constant;
a plasma generating step (ST3) of generating a glow discharge plasma by applying an electric power to an electrode (102) provided in said plasma processing reaction chamber (101);
a gas control step (ST4) of introducing an etching gas into said plasma processing reaction chamber (101) and increasing a flow rate of said etching gas while simultaneously decreasing a flow rate of said diluent gas by an amount substantially equal to an increase of the flow rate of said etching gas; and
an etching step (ST5) of performing etching by setting respective flow rates of said diluent gas and said etching gas to processing flow rate values respectively,
said diluent gas introducing step, said pressure adjusting step, said plasma generating step, said gas control step and said etching step being performed in this order.

2. The plasma etching method according to claim 1, wherein
in said gas control step (ST4), the step of introducing said etching gas and increasing the flow rate of said etching gas while simultaneously decreasing the flow rate of said diluent gas by the amount substantially equal to an increase of the flow rate of said etching gas is performed a plurality of times.

3. The plasma etching method according to claim 1, wherein
in said gas control step (ST4), respective flow rates of said diluent gas and said etching gas are changed continuously.

4. The plasma etching method according to claim 1, wherein
in said gas control step (ST4), respective flow rates of said diluent gas and said etching gas are changed step by step.

5. The plasma etching method according to claim 1, wherein
in said gas control step (ST4), a ratio of the flow rate of said etching gas to the flow rate of said diluent gas is increased continuously or step by step.

6. The plasma etching method according to claim 1, wherein
the flow rate of said diluent gas in said diluent gas introducing step (ST1) and a total flow rate of said diluent gas and said etching gas in said etching step (ST5) are made equal to each other.

7. The plasma etching method according to claim 1, wherein
the flow rate of said diluent gas from said pressure adjusting step (ST2) to said plasma generating step (ST3) and a total flow rate of said diluent gas and said etching gas from said gas control step (ST4) to said etching step (ST5) are made equal to each other.

8. The plasma etching method according to claim 1, wherein
the electric power applied to said electrode (102) in said plasma generating step (ST3) is set to an initial electric power value, said electric power is increased from said gas control step (ST4) to said etching step (ST5), and said electric power is fixed when said electric power reaches a processing electric power value in said etching step (ST5).

9. The plasma etching method according to claim 8, wherein
said electric power is increased continuously in said gas control step (ST4) and said etching step (ST5).

10. The plasma etching method according to claim 8, wherein
the electric power applied to said electrode (102) is fixed at said processing electric power value after an end of said gas control step (ST4) and after the flow rate of the gases becomes stable.

11. The plasma etching method according to claim 1, wherein
the electric power applied to said electrode (102) in said plasma generating step (ST3) is made equal to an electric power applied to said electrode (102) in said etching step (ST5).

12. The plasma etching method according to claim 1, wherein
an impedance matching circuit (105) is provided between said electrode (102) and a power supply (104) supplying an electric power to said electrode (102), and said impedance matching circuit (105) is fixed in an impedance-matched state in a steady state of said etching step (ST5).

13. The plasma etching method according to claim 12, wherein
after a predetermined period of time has passed since an end of said gas control step (ST4), said impedance matching circuit (105) starts an automatic matching operation.

14. The plasma etching method according to claim 1, wherein
an impedance matching circuit (105) is provided between said electrode (102) and a power supply (104) supplying an electric power to said electrode (102) and, from said plasma generating step (ST3) to a time when a predetermined period of time has passed since an end of said gas control step (ST4), said impedance matching circuit (105) is set in a state where a reflected electric power is minimum in a steady state of said etching step (ST5).

15. The plasma etching method according to claim 1, wherein
a plurality of said electrodes (102) are provided in said plasma processing reaction chamber (101), and a power supply (104) is connected via an impedance matching circuit (105) to said plurality of electrodes (102).

16. The plasma etching method according to claim 1, wherein
a plasma etching apparatus with which said plasma etching method is performed is used as both of the plasma etching apparatus and a plasma CVD apparatus.
